Europäisches Patentamt

European Patent Office

Office européen des brevets

(19)

(11) **EP 0 430 158 B1**

(12)

# EUROPEAN PATENT SPECIFICATION

(45) Date of publication and mention
of the grant of the patent:
**05.02.1997 Bulletin 1997/06**

(51) Int Cl.⁶: **G11C 7/00**, G11C 11/419

(21) Application number: **90122637.3**

(22) Date of filing: **27.11.1990**

(54) **Semiconductor memory device**

Halbleiterspeicheranordnung

Dispositif de mémoire à semi-conducteurs

(84) Designated Contracting States:
**DE FR GB**

(30) Priority: **27.11.1989 JP 307228/89**

(43) Date of publication of application:
**05.06.1991 Bulletin 1991/23**

(73) Proprietor: **KABUSHIKI KAISHA TOSHIBA**
**Kawasaki-shi, Kanagawa-ken 210 (JP)**

(72) Inventors:
• **Matsumoto, Naoki**
**Ota-ku, Tokyo-To (JP)**
• **Watanabe, Yuji**
**Kawasaki-shi, Kanagawa-ken (JP)**
• **Ohshima, Shigeo**
**Yokohama-shi, Kanagawa-ken (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
**EP-A- 0 317 012**          **US-A- 4 764 899**
**US-A- 4 817 054**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

<u>FIELD OF THE INVENTION</u>

The present invention relates to a semiconductor memory device, and more particularly to a semiconductor memory device of the type that high speed data access is carried out at high speed cycle time.

<u>BACKGROUND OF THE INVENTION</u>

For memories such as static random access memories (RAM) and multi-port memories of the type that high speed data accesses are carried out sequentially at high speed cycle time, it is necessary to execute a series of data reading operations as fast as possible. A series of data reading operations by such memories includes the following operations. Namely, memory cells or data registers are selected. The data read therefrom are outputted to a common data bus pair (DQ line pair) and amplified by sense amplifiers at several stages to MOS logic levels. The amplified data are supplied to a common data output buffer and outputted to an external output pin as a "0" level data or a "1" level data. Such a series of operations is required to be carried out at high speed.

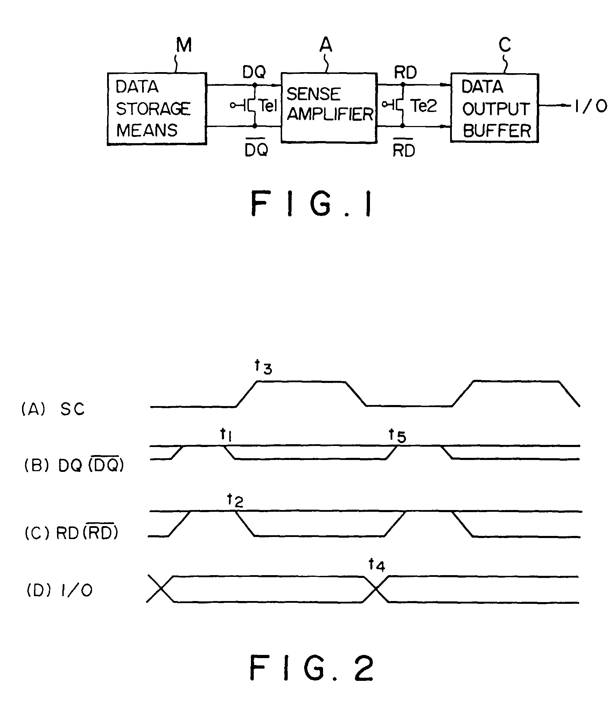

Fig. 1 is a block diagram showing a semiconductor integrated circuit. As shown in Fig. 1, complementary data read from data storage means M such as a memory cell are outputted onto a pair of data busses DQ and $\overline{DQ}$ (DQ line pair). The data on the DQ line pair are amplified by a sense amplifier A to a power supply potential level $V_{CC}$ and to a ground potential level $V_{SS}$, respectively, and outputted onto a RD line pair of RD and $\overline{RD}$. In accordance with a pair of data on the RD line pair, a "1" level signal or a "0" level signal is outputted to an external output pin I/O via a data output buffer C.

In Fig. 1, Te1 and Te2 represent equalizing transistors which equalize the DQ line pair and RD line pair, respectively.

The circuit constructed as above operates in the manner shown in the timing chart of Fig. 2. In Fig. 2, Fig. 2(A) shows a cycle signal SC which indicates a data read cycle for reading a data from a memory, Fig. 2(B) shows a signal on the DQ line pair inputted to the sense amplifier A, Fig. 2(C) shows a signal on the RD line pair inputted from the sense amplifier A to the data output buffer C, and Fig. 2(D) shows a signal outputted from the data output buffer C to the external output pin I/O.

The data read from a memory cell or the like appear at the DQ line pair at time t1. The read-out data are supplied to and amplified by the sense amplifier A to the power supply potential level $V_{CC}$ and to a ground potential level $V_{SS}$, i.e., to MOS logic levels. Thereafter, at time t2 the amplified signals are outputted from the sense amplifier A onto the RD line pair. In response to a change of the cycle signal SC at time t3, the data output buffer C latches the data on the RD line pair at time t4 and outputs the data to the external output pin I/O.

The above operations are repeated to sequentially read data from different memory cells. After the data from a memory cell or the like (data on the RD line pair) are loaded in the data output buffer C, the DQ line pair and RD line pair are equalized at time t5 before the next data are read from a memory cell.

The semiconductor integrated circuit operates in the above-described manner. It is therefore possible to read information in a memory cell or data register and output the information onto the DQ line pair at high speed. However, the sense amplifier A must continue to latch the data on the RD line pair while the data on the RD line are transferred to the data output buffer C.

As described above, after the data on the RD line pair were loaded in the data output buffer C, the DQ line pair and RD line pair are equalized and thereafter, the data on the DQ line pair for the next cycle are sensed and amplified by the sense amplifier A and outputted onto the RD line pair. In this case, however, as the cycle time becomes shorter, it becomes difficult to complete the equalization of the DQ line pair before the next cycle data are read, resulting in a residual hysteresis which causes a high possibility of a read error at the next cycle.

Particularly in the case where an access address for the next cycle has been already determined as in the case of a serial port of a multi-port memory, high speed data access and high speed cycle time depend on the time from the start of data latch on the RD line pair by the sense amplifier to the end of equalizing the DQ line pair.

In order to realize high speed data access and high speed cycle time of the operation of the circuit, the amplitudes of signals on the RD line pair may be made large. To this end, it becomes necessary to make the driving power of the sense amplifier A larger. Accordingly, power consumption increases, and moreover a logic level inputted from the external is likely to be detected erroneously because of power source noises.

From US 4.817.054 a semiconductor memory device is known, comprising data storage means, complementary data lines for reading out data from the storage means, equalizing means connected accross the complementary data lines, amplifying means connected to the complementary data lines and data latching means including latch means and switching means. Moreover, from this document, a data output buffer is known.

From IEEE Journal of Solid State Circuits, Volume SC-21, No. 5, October 1986, New York, USA, pages 692 to 703, Flannagan et al: Two 13-ns 64K CMOS SRAM's with Very Low Active Power and Improved Asynchronous Circuit Techniques" an output buffer latch circuit is known that has its pair of complementary input lines both selectively pulled to ground to bring the data output into high impedance state.

## SUMMARY OF THE INVENTION

The present invention has been made in consideration of the above problems. It is an object of the present invention to provide a semiconductor integrated circuit capable of high speed data access at high speed cycle time.

This object is solved according to the present invention as defined in claim 1.

## BRIEF DESCRIPTION OF THE DRAWINGS

Fig. 1 is a block diagram showing a semiconductor integrated circuit according to a background art;
Fig. 2 is a timing chart used for explaining the operation of the circuit shown in Fig. 1;
Fig. 3 is a block diagram showing an embodiment of this invention;
Fig. 4 shows an example of the detailed circuit shown in Fig. 3; and
Fig. 5 is a timing chart used for explaining the operation of the circuit shown in Fig. 3.

## DESCRIPTION OF THE PREFERRED EMBODIMENT

An embodiment of this invention will be described with reference to the accompanying drawings.

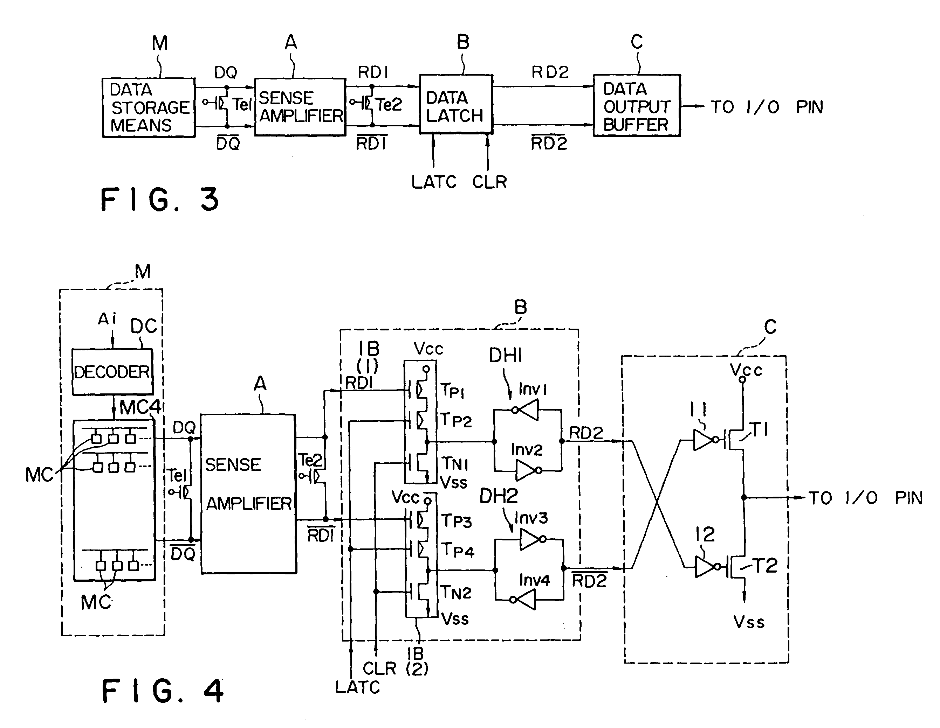

Fig. 3 is a block diagram showing an embodiment of this invention. Referring to Fig. 3, a first RD line pair (RD1, $\overline{RD1}$) at the output side of a sense amplifier A is connected to a data latch circuit B. To the data latch circuit B, there are supplied two control signals LATC and CLR. A second RD line pair (RD2, $\overline{RD2}$) at the output side of the data latch circuit B is connected to a data output buffer C. The other circuit structure is the same as that shown in Fig. 1.

Fig. 4 is a detailed circuit diagram showing an example of the data latch circuit B shown in Fig. 3. In Fig. 4, a circuit having a memory cell array MCA is shown as data storage means M. This circuit also has a decoder DC to which an address Ai is supplied. The decoder DC decodes the address Ai to select one memory cell MC of the memory cell array MCA. Complementary signals corresponding to the data in the selected memory cell are supplied to the sense amplifier A via the DQ line pair. Signals on the first RD line pair outputted from the sense amplifier A are applied to the gates of P-type transistors $T_{p1}$ and $T_{p3}$ of an input buffer IB. A signal from the transistor $T_{p1}$ passes through a P-type transistor $T_{p2}$, the gate of which is supplied with the latch signal LATCH, and is supplied to a data holding circuit DH1 constructed of inverse-and-parallel connected inverters Inv1 and Inv2. On the other hand, a signal from the transistor $T_{p3}$ passes through a P-type transistor $T_{p4}$, the gate of which is supplied with the latch signal LATCH, and is supplied to a data holding circuit DH2 constructed of inverse-and-parallel connected inverters Inv3 and Inv4. The outputs of the data holding circuits DHI and

DH2 are supplied to the second RD line pair (RD2, $\overline{RD2}$).

Signals on the first RD line pair are sampled by the data holding circuits DH1 and DH2 while the latch signal LATC takes a "0" level. While the latch signal LATC takes a "1" level, the signals on the first RD line pair latched at the preceding cycle and held by the data latch circuits DH1 and DH2 are outputted onto the second RD line pair.

N-type transistors $T_{N1}$ and $T_{N2}$ to which gates the clear signal CLR are inputted, are serially connected to the P-type transistors $T_{p2}$ and $T_{p4}$ respectively. The other terminals of the transistors $T_{N1}$ and $T_{N2}$ are connected to the ground potential $V_{SS}$ terminal. The transistors $T_{N1}$ and $T_{N2}$ are provided for canceling data hysteresis for the operation of the next cycle. Namely, the transistors $T_{N1}$ and $T_{N2}$ are supplied with the clear signal CLR immediately before outputting data so that the second RD line pair (RD2, $\overline{RD2}$) is pre-charged to the "H" level.

The data output buffer C at the next stage is constructed of N-type transistors T1 and T2 which are serially connected between the power source potential $V_{CC}$ and ground potential $V_{SS}$. The gates of the transistors T1 and T2 are connected via respective inverters I1 and I2 to the output terminals ($\overline{RD2}$, RD2) of the data holding circuit DH2 and DH1.

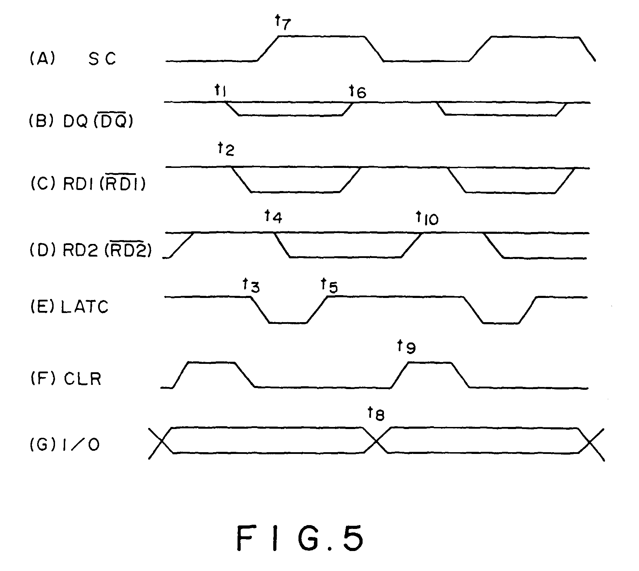

The operation of the circuit shown in Fig. 4 will be described with reference to the diagram shown in Fig. 5. Fig. 5 shows signal waveforms at various points of the circuit shown in Fig. 4. Fig. 5(A) shows a cycle signal SC which indicates a data read cycle for reading a data from a memory cell, Fig. 5(B) shows a signal on the DQ line pair inputted to the sense amplifier A, Fig. 5(C) shows a signal on the first RD line pair inputted from the sense amplifier A to the data latch circuit B, Fig. 5(D) shows a signal on the second RD line pair outputted from the data latch circuit B to the data output buffer C, Fig. 5(E) shows the latch signal LATC supplied to the data latch circuit B, Fig. 5(F) shows the clear signal CLR supplied to the data latch circuit B, and Fig. 5(G) shows a signal outputted from the data output buffer C to the external output pin I/O.

The data read from a memory cell MC appear at the DQ line pair at time t1. The read-out data are supplied to and amplified by the sense amplifier A to the power source potential level $V_{CC}$ and ground potential level $V_{SS}$, i.e., to MOS logic levels. Thereafter, at time t2 the amplified signals are supplied to the first RD line pair.

The latch signal LATC takes an "H" level at time t2 so that the data on the first RD line pair are blocked by the data latch circuit B and do not appear at the second RD line pair. Thereafter, the latch signal LATC takes an "L" level at time t3 so that the data latch circuit B becomes through so that the data on the first RD line pair appear at the second RD line pair at time t4. Thereafter, at time t5 the latch signal LATC takes the "H" level so that the data latch circuit B enters a latch state and the data on the first RD line pair are latched and the data on the second RD line pair are maintained unchanged. Thereafter, at time t6, the DQ line pair and first RD line pair are equalized, this equalization not influencing the second RD line pair. At time t8, the data on the second RD line pair are latched by the data output buffer C and outputted to the external output pin I/O.

The clear signal CLR inputted at time t9 causes the N-type transistors $T_{N1}$ and $T_{N2}$ to turn on so that the inverters Inv2 and Inv3 are turned on and the second RD line pair is pre-charged to the "H" level at time t10. In other words, after the data output buffer C latches the output data to the I/O pin, the second RD line pair is pre-charged to the "H" level so that the hysteresis at the previous cycle can be removed.

As described so far, according to the embodiment of this invention, a latch circuit for latching the sensed data from a register or memory cell is provided between a sense amplifier and a data output buffer. Therefore, immediately after the sense amplifier senses the data on the DQ line pair, data transfer to the data output buffer and equalization of the DQ line pair can be executed in parallel at the same time. Accordingly, there is solved the problem that high speed data access and high speed cycle time for such as a serial port of a multi-port memory depend on the time required from the start of latching data on the RD line pair to the end of equalizing the DQ line pair. High speed data access and cycle time can therefore be realized, while reducing power consumption and power supply noises. In other words, the operation of outputting the data latched by the latch circuit can be executed at the same time when the data lines at the output/input sides of an amplifier are equalized for outputting the next data, thereby realizing high speed data output.

Reference signs in the claims are intended for better understanding and shall not limit the scope.

## Claims

1. A semiconductor memory device having:

   data storage means (M) having a plurality of memory cells (MC) each capable of storing a data and being selected by an address (Ai), first complementary data corresponding to the data in a selected memory cell being outputted to first complementary data lines (DQ, $\overline{DQ}$);

   first equalizing means (Tel) for short-circuiting to equalize said first complementary data lines (DQ, $\overline{DQ}$);

   an amplifier circuit (A) for receiving said first complementary data from said data storage circuit (M) through said first complementary data lines (DQ, $\overline{DQ}$), and for making large the difference between levels of said first complementary data, and outputting as second complementary data said levels to second complementary data lines (RD1, $\overline{RD1}$);

second equalizing means (Te2) for short-circuiting to equalize said second complementary data lines (RD1, $\overline{RD1}$);

data latching means (B) having latch means (DH1, DH2) and switching means (IB1, IB2), said latch means receiving and latching said second complementary data from said second complementary data lines (RD1, $\overline{RD1}$), and outputting as third complementary data said second complementary data to third complementary data lines (RD2 $\overline{RD2}$), said switching means connecting/disconnecting said second complementary data lines (RD1, $\overline{RD1}$), between said second equalizing means (Te2) and said latch means (DH1, DH2); and

output means (C) for receiving said third complementary data from said third complementary data lines (RD2 $\overline{RD2}$) and outputting an output signal corresponding to said third complementary data;

said switching means (IB1, IB2) comprising a first switch (IB1) and a second switch (IB2); each of said first switch (IB1) and said second switch (IB2) comprising

a first P-channel transistor (TP1, TP3), a second P-channel transistor (TP2, TP4) and a third N-channel transistor (TN1; TN2) connected in series between a high voltage side supply voltage (Vcc) and a low voltage side supply voltage (Vss);

said latch means (DH1, DH2) comprising a first latch (DH1) and a second latch (DH2), said first latch (DH1) and second latch (DH2) being connected between an intermediate point between the second and third transistors (Tp2; TN1; TP4, TN2) of the first switch (IB1) and second switch (IB2), respectively, and the respective line of said third complementary data lines (RD2 $\overline{RD2}$);

each of the second complementary data lines (RD1, $\overline{RD1}$),being connected to a gate of the first transistor (TP1; TP3) of said first switch (IB1) and second switch (IB2), respectively, a latch signal (LATC) being applied to a gate of the second transistors (TP2; TP4) and a clear signal (CLR) being applied to a gate of the third transistors (TN1; TN2), respectively; and further the memory device has means for repeatedly operating the memory in sequence in the order of first, second and third operations as follows:

in the first operation, the latch signal (LATC) and the clear signal (CLR) are both set to an H-level to turn off and on the second and third transistors (TP2, TN1; TP4, TN2), respectively, so that the third data lines (RD2, $\overline{RD2}$) are precharged to the H-level via the latch means (DH1, DH2);

in the second operaton, the latch signal (LATC) and the clear signal (CLR) are both set to an L-level to turn on and off the second and third transistors (TP2, TN1; TP4, TN2), respectively, so that data on the second data lines (RD2, $\overline{RD2}$) are latched by the latch means (DH1, DH2), and

in the third operation, the latch signal (LATC) and the clear signal (CLR) are both set to the H-level and the L-level, respectively to turn off both the second and third transistors (TP2, TN1; TP4, TN2), so that the latch means (DH1, DH2) are disconnected away from the amplifier circuit (A) to equalize the second data lines (RD1, $\overline{RD1}$), without exerting any influence upon the data output when the latch means (DH1, DH2) is outputting data stored therein.

2.  The semiconductor memory device of claim 1, wherein each of the latch means (DH1, DH2) is formed by connecting two inverters (Invl, Inv2; Inv3, Inv4) inversely in parallel to each other.

3.  The semiconductor memory device of claim 2, wherein the amplifier circuit (A) senses and amplifies data received through said pair of first complementary data lines (DQ, $\overline{DQ}$), and outputs the sensed and amplified data to said pair of second complementary data lines (RD1, $\overline{RD1}$) as a high-voltage side supply voltage (Vcc) and a low-voltage side supply voltage (Vss), respectively.

**Patentansprüche**

1.  Halbleiterspeichervorrichtung mit:

einer Datenspeichervorrichtung (M), welche eine Vielzahl von Speicherzellen (MC) hat, von denen jede in der Lage ist, Daten zu speichern und von einer Adresse (Ai) ausgewählt zu werden, wobei erste komplementäre Daten dem Ausgeben von Daten in einer ausgewählten Speicherzelle auf erste komplementäre Datenleitungen (DQ, $\overline{DQ}$) entsprechen;

eine erste Entzerrungsvorrichtung (Te1) zum Kurzschließen, um die ersten komplementären Datenleitungen (DQ, $\overline{DQ}$) zu entzerren;

eine Verstärkerschaltung (A) zum Empfangen der ersten komplementären Daten von der Datenspeicherschaltung (M) über die ersten komplementären Datenleitungen (DQ, $\overline{DQ}$), und zur Vergrößerung der Differenz zwischen Pegeln der ersten komplementären Daten, und zur Ausgabe der Pegel als zweite komplementäre Daten an zweite komplementäre Datenleitungen (RD1, $\overline{RD1}$);

eine zweite Entzerrungsvorrichtung (Te2) zum Kurzschließen, um die zweiten komplementären Datenleitungen (RD1, $\overline{RD1}$ zu entzerren;

eine Dateneinklinkvorrichtung (B) mit einer Einklinkvorrichtung (DH1, DH2) und einer Schaltvorrichtung (IB1, IB2), wobei die Einklinkvorrichtung die zweiten komplementären Daten von den zweiten komplementären Datenleitungen (RD1, $\overline{RD1}$) empfängt und einklinkt, und die zweiten komplementären Daten als dritte komplementäre Daten an dritte komplementäre Datenleitungen (RD2, $\overline{RD2}$) ausgibt, wobei die Schaltvorrichtung die zweiten komplementären Datenleitungen (RD1, $\overline{RD1}$) Anschließt/ Trennt, zwischen der zweiten Entzerrungsvorrichtung (Te2) und der Einklinkvorrichtung (DH1, DH2);

eine Ausgabevorrichtung (C) zum Empfangen der dritten komplementären Daten von den dritten komplementären Datenleitungen (RD2, $\overline{RD2}$) und zur Ausgabe eines Ausgabesignals, welches den dritten komplementären Daten entspricht;

wobei die Schaltvorrichtung (IB1, IB2) einen ersten Schalter (IB1) und einen zweiten Schalter (IB2) umfaßt; wobei jeder der ersten und zweiten Schalter umfaßt:

einen ersten P-Kanal Transistor (TP1, TP3), einen zweiten P-Kanal Transistor (TP2, TP4) und einen dritten P-Kanal Transistor (TN1; TN2), welche in Reihe zwischen einer Hochspannungsseiten-Versorgungspannung (Vcc) und einer Niedrigspannungsseiten-versorgungsspannung (Vss) angeschlossen sind;

wobei die Einklinkvorrichtung (DH1, DH2) einen ersten Halter (DH1) und einen zweiten Halter (DH2) umfaßt, wobei der erste Halter (DH1) und der zweite Halter (DH2) zwischen einem mittleren Punkt zwischen den zweiten und dritten Transistoren (Tp2; TN1; TP4, TN2) des ersten Schalters (IB1) bzw. des zweiten Schalters (IB2) und der jeweiligen Leitung der dritten komplementären Datenleitungen (RD2, $\overline{RD2}$) angeschlossen sind;

wobei jede der zweiten komplementären Leitungen (RD1, $\overline{RD1}$) mit einem Gate des ersten Transistors (TP1; TP3) des ersten Schalters (IB1) bzw. des zweiten Schalters (IB2) verbunden ist, wobei ein Einklinksignal (LATC) an ein Gate des zweiten Transistors (TP2; TP4) bzw. ein Rücksetzsignal (CLR) an ein Gate des dritten Transistors (TN1; TN2) angelegt wird, und ferner die Speichervorrichtung eine Einrichtung hat, um wiederholt den Speicher in Sequenz in der Reihenfolge erster, zweiter und dritter Vorgänge wie folgt zu betreiben:

bei dem ersten Vorgang werden das Enklinksignal (LATC) und das Rücksetzsignal (CLR) beide auf einen H-Pegel gestellt, um die zweiten und dritten Transistoren (TP2, TN1; TP4, TP2) aus- bzw. einzuschalten, so daß die dritten Datenleitungen (RD2, $\overline{RD2}$) auf den H-Pegel über die Einklinkvorrichtung (DH1, DH2) vorgeladen werden;

bei dem zweiten Vorgang werden das Einklinksignal (LATC) und das Rücksetzsignal (CLR) beide auf einen L-Pegel gestellt, um die zweiten und dritten Transistoren (TP2,TP1; TP4,TN2) ein- bzw. auszuschalten, so daß Daten auf den zweiten Datenleitungen (RD2, $\overline{RD2}$) von der Einklinkvorrichtung (DH1, DH2) eingeklinkt werden, und

beim drittem Vorgang werden das Einklinksignal (LATC) und das Rücksetzsignal (CLR) beide auf den H-Pegel bzw. den L-Pegel gesetzt, um die zweiten und dritten Transistoren (TP2, TN1; TP4, TN2) auszuschalten, so daß die Einklinkvorrichtung (DH1, DH2) von der Verstärkerschaltung (A) getrennt ist, um die zweiten Datenleitungen (RD1, $\overline{RD1}$) zu entzerren, ohne Ausübung irgendeines Einflusses auf die Datenausgabe, wenn die Einklinkvorrichtung (DH1, DH2) darin gespeicherte Daten ausgibt.

2. Halbleiterspeichervorrichtung nach Anspruch 1, wobei jede der Einklinkvorrichtungen (DH1, DH2) durch zwei Inverter (Inv1, Inv2; Inv3, Inv4) gebildet ist, welche invers parallel zu einander verbunden sind.

3. Halbleiterspeichervorrichtung nach Anspruch 2, in welcher die Verstärkerschaltung (A) Daten aus dem Paar von ersten komplementären Datenleitungen

(DQ, $\overline{DQ}$) liest und verstärkt, und die gelesenen und verstärkten Daten an das Paar von zweiten komplementären Datenleitungen (RD1, $\overline{RD1}$) als eine Hochspannungsseiten-Versorgungsspannung (Vcc) bzw. eine Niedrigspannungsseiten-Versorgungsspannung (Vss) ausgibt.

**Revendications**

1. Dispositif de mémoire à semiconducteur comprenant :

un moyen de stockage de données (M) comportant une pluralité de cellules de mémoire (MC) dont chacune peut stocker des données et peut être choisie par une adresse (Ai), des premières données complémentaires correspondant aux données dans une cellule de mémoire sélectionnée étant émises en sortie sur des premières lignes de données complémentaires (DQ, $\overline{DQ}$) ;
un premier moyen d'égalisation (Te1) pour réaliser un court-circuit afin d'égaliser lesdites premières lignes de données complémentaires (DQ, $\overline{DQ}$) ;
un circuit d'amplificateur (A) pour recevoir lesdites premières données complémentaires provenant dudit circuit de stockage de données (M) par l'intermédiaire desdites premières lignes de données complémentaires (DQ, $\overline{DQ}$) et pour rendre importante la différence entre des niveaux desdites premières données complémentaires et pour émettre en sortie en tant que secondes données complémentaires lesdits niveaux sur des secondes lignes de données complémentaires (RD1, $\overline{RD1}$) ;
un second moyen d'égalisation (Te2) pour réaliser un court-circuit afin d'égaliser lesdites secondes lignes de données complémentaires (RD1, $\overline{RD1}$) ;
un moyen de verrouillage de données (B) comportant un moyen de bascule (DH1, DH2) et un moyen de commutation (IB1, IB2), ledit moyen de bascule recevant et verrouillant lesdites secondes données complémentaires provenant desdites secondes lignes de données complémentaires (RD1, $\overline{RD1}$) et émettant en sortie en tant que troisièmes données complémentaires lesdites secondes données complémentaires sur des troisièmes lignes de données complémentaires (RD2, $\overline{RD2}$), ledit moyen de commutation connectant/déconnectant lesdites secondes lignes de données complémentaires (RD1, $\overline{RD1}$) entre ledit second moyen d'égalisation (Te2) et ledit moyen de bascule (DH1, DH2); et
un moyen de sortie (C) pour recevoir lesdites troisièmes données complémentaires provenant desdites troisièmes lignes de données complémentaires (RD2, $\overline{RD2}$) et pour émettre en sortie un signal de sortie correspondant auxdites troisièmes données complémentaires ; ledit moyen de commutation (IB1, IB2) comprenant un premier commutateur (IB1) et un second commutateur (IB2), chacun desdits premier (IB1) et second (IB2) commutateurs comprenant :

un premier transistor à canal P (TP1, TP3), un second transistor à canal P (TP2, TP4) et un troisième transistor à canal N (TN1; TN2) connectés en série entre une tension d'alimentation de côté haute tension (Vcc) et une tension d'alimentation de côté basse tension (Vss) ; ledit moyen de bascule (DH1, DH2) comprenant une première bascule (DH1) et une seconde bascule (DH2), ladite première bascule (DH1) et ladite seconde bascule (DH2) étant connectées entre un point intermédiaire entre respectivement les second et troisième transistors (TP2; TN1; TP4, TN2) des premier (IB1) et second (IB2) commutateurs et la ligne respective desdites troisièmes lignes de données complémentaires (RD2, $\overline{RD2}$) ;

chacune des secondes lignes de données complémentaires (RD1, $\overline{RD1}$) étant respectivement connectée à une grille du premier transistor (TP1; TP3) dudit premier commutateur (IB1) et dudit second commutateur (IB2), un signal de bascule (LATC) étant appliqué sur une grille des seconds transistors (TP2; TP4) et un signal de remise à zéro (CLR) étant respectivement appliqué sur une grille des troisièmes transistors (TN1; TN2) ; et en outre, le dispositif de mémoire comporte un moyen pour activer de façon répétée la mémoire en séquence selon l'ordre de première, seconde et troisième opérations comme suit :

lors de la première opération, le signal de bascule (LATC) et le signal de remise à zéro (CLR) sont tous deux établis à un niveau H pour respectivement rendre bloqué et passant les second et troisième transistors (TP2, TN1 ; TP4, TN2) de telle sorte que les troisièmes lignes de données (RD2, $\overline{RD2}$) soient préchargées au niveau H via le moyen de bascule (DH1, DH2) ;

lors de la seconde opération, le signal de bascule (LATC) et le signal de remise à zéro (CLR) sont tous deux établis à un niveau L pour respectivement de rendre passant et bloqué les second et troisième transistors (TP2, TN1; TP4, TN2) de telle sorte que des données sur les secondes lignes de données (RD2, $\overline{RD2}$) soient verrouillées par le moyen de bascule (DH1, DH2) ; et

lors de la troisième opération, le signal de bascule (LATC) et le signal de remise à zéro (CLR) sont tous deux établis au niveau H et au niveau L pour respectivement rendre bloqués à la fois les second et troisième transistors (TP2, TN1 ; TP4, TN2) de telle sorte que le moyen de bascule (DH1, DH2) soit déconnecté du circuit d'amplificateur (A) afin d'égaliser les secondes lignes de données (RD1, $\overline{RD1}$) sans exercer une quelconque influence sur la sortie de données lorsque le moyen de bascule (DH1, DH2) est en train d'émettre en sortie des données stockées dedans.

2. Dispositif de mémoire à semiconducteur selon la revendication 1, dans lequel chacun des moyens de bascule (DH1, DH2) est formé en connectant deux inverseurs (Inv1, Inv2 ; Inv3, Inv4) de façon inverse en parallèle l'un à l'autre.

3. Dispositif de mémoire à semiconducteur selon la revendication 2, dans lequel le circuit d'amplificateur (A) détecte et amplifie des données reçues par l'intermédiaire de ladite paire de premières lignes de données complémentaires (DQ, $\overline{DQ}$) et émet en sortie les données détectées et amplifiées sur ladite paire de secondes lignes de données complémentaires (RD1, $\overline{RD1}$) en tant que respectivement tension d'alimentation de côté haute tension (Vcc) et tension d'alimentation de côté basse tension (Vss).

F I G . I

F I G . 2

FIG. 3

FIG. 4

(A)  S C

(B) DQ ($\overline{DQ}$)

(C) RDI ($\overline{RDI}$)

(D) RD2 ($\overline{RD2}$)

(E) LATC

(F) CLR

(G) I／O

$t_7$

$t_1$      $t_6$

$t_2$

$t_4$      $t_{10}$

$t_3$      $t_5$

$t_9$

$t_8$

F I G. 5